# FASCICULE DE BREVET EUROPEEN

(11) **EP 1 413 632 B1**
(45) Date de publication et mention de la délivrance du brevet: **22.03.2006**
(21) Numéro de dépôt: 03027268.6
(22) Date de dépôt: 14.01.2000
(51) Int. Cl.: C21D 8/12, B32B 15/04, H01F 41/02, H01F 27/245, H01F 1/153

(54) **Procédé de traitement d'une bande mince métallique fragile et pièces magnétiques réalisées à partir d'une bande en alliage nanocristallin**
Verfahren zum Behandeln eines dünnen und zerbrechlichen Metallbandes und aus einem nanokristallinen Legierungsband hergestellte magnetische Werkstücke
Method for treating a brittle thin metal strip and magnetic parts made from a nanocrystalline alloy strip

(30) Priorité: 19.01.1999 FR 9900521
(43) Date de publication de la demande: 28.04.2004
(62) Demande divisionnaire de: 00900585.1
(73) Titulaire: Imphy Alloys, 92800 Puteaux (FR)
(72) Inventeur: Reyal, Jean-Pierre, 95610 Eragny (FR); Schmit, Francis, 60250 Ansacq (FR)
(74) Mandataire: Lagrange, Jacques Etienne M.M.

(56) Documents cités:
- EP-A- 0 687 134
- EP-A- 0 695 812
- WO-A-91/12960
- US-A- 4 201 837
- US-A- 4 558 297
- US-A- 4 808 464
- PATENT ABSTRACTS OF JAPAN vol. 0183, no. 82 (E-1580), 19 juillet 1994 (1994-07-19) & JP 6 112031 A (HITACHI METALS LTD), 22 avril 1994 (1994-04-22)

## Description

L'invention concerne un procédé de traitement d'une bande mince métallique fragile et des produits obtenus à l'issue du traitement de la bande qui peut comporter des opérations de mise en forme telles qu'un découpage. En particulier, le procédé est relatif à l'obtention, par découpage dans une bande métallique, de pièces à usage magnétique ayant une structure nanocristalline.

On a proposé de fabriquer des bandes minces en alliage magnétique et en particulier en alliage à haute perméabilité, qui présentent une structure constituée principalement de grains très fins dans une matrice amorphe dont la taille peut être comprise par exemple entre 1 et 100 nm. De tels alliages sont appelés alliages nanocristallins.

Les matériaux métalliques nanocristallins sont obtenus, sous forme de bandes minces, par exemple d'une épaisseur de l'ordre de 20 µm, à partir de bandes ou rubans amorphes réalisés par coulée et refroidissement rapide d'un métal liquide sur un cylindre ou entre deux cylindres refroidis. Les bandes ou rubans amorphes sont traités thermiquement par maintien à une température de l'ordre de 550°C pendant une durée de l'ordre d'une heure, de manière qu'ils développent une structure nanocristalline, dans une partie substantielle, par exemple supérieure à 50 %, de leur volume.

Ce traitement thermique peut être précédé par des traitements thermiques préalables à des températures inférieures, par exemple de l'ordre de 200°C.

Lorsqu'on réalise la coulée, le refroidissement puis le traitement thermique d'alliages à base de fer magnétiquement doux, on peut obtenir, à partir de la bande à l'état nanocristallin, des produits tels que des noyaux de circuit magnétique, présentant d'excellentes propriétés magnétiques qui ne peuvent être obtenues généralement, dans le cas de matériaux dont la structure est différente d'une structure nanocristalline.

Cependant, un inconvénient des bandes ou rubans ayant une structure nanocristalline est que ces bandes ou rubans sont d'une très grande fragilité de telle sorte que la moindre sollicitation mécanique provoque une rupture de la bande ou ruban. Il n'est même pas possible de manipuler les bandes ou rubans de structure nanocristalline sans prendre de très grandes précautions, du fait que des contraintes, même très faibles, induites dans la bande conduisent à sa rupture fragile. Le seul procédé connu actuellement pour fabriquer des composants magnétiques tels que des noyaux magnétiques, à partir de bandes à structure nanocristalline, consiste à enrouler la bande d'alliage magnétique à l'état amorphe, puis de traiter thermiquement cette bande à la température à laquelle se développe la structure nanocristalline. Le traitement thermique peut être réalisé éventuellement sous champ magnétique pour modifier le cycle d'hystérésis de ces alliages nanocristallins.

Il n'est donc pas possible actuellement de fabriquer des composants magnétiques nanocristallins par des opérations de traitement mécanique ou d'usinage comportant, par exemple, un découpage.

L'obtention, à partir de bandes en alliage magnétique nanocristallin, de composants magnétiques ayant un contour dont la forme géométrique est bien définie présente un très grand intérêt. En particulier, il serait extrêmement intéressant de pouvoir fabriquer, à partir de bandes nanocristallines, des pièces magnétiques ayant la forme de rondelles, des formes en U ou en E ou encore des pièces ayant des formes complexes utilisées pour l'horlogerie.

De manière plus générale, il peut être extrêmement intéressant de disposer d'un procédé permettant le traitement d'une bande mince métallique fragile, d'une épaisseur faible, généralement inférieure à 0,1 mm, le traitement de la bande mettant en oeuvre au moins une étape dans laquelle la bande fragile est soumise à des contraintes, notamment de découpage ou de pliage.

Dans le EP-0.687.134, on a proposé de réaliser un transformateur miniaturisé comportant un noyau magnétique stratifié comportant une pluralité de bandes minces nanocristallines liées entre elles par des couches de résine. Le stratifié comportant une pluralité de bandes minces nanocristallinés est coupé aux dimensions du noyau à obtenir.

Dans le US-4,558,247, on décrit un noyau saturable comportant une bande en alliage magnétique amorphe enroulée et un film isolant intercalé entre les spires successives du noyau.

US-A-4 808 464 divulgue la production de transformateurs à noyau par le recouvrement d'une bande en alliage ferromagnetique amorphe par une couche isolante de verre, suivi du séchage et de la découpe de la bande recouverte, les pièces coupées étant ensuite superposées et recuites.

Le but de l'invention est de proposer un procédé de traitement d'au moins une bande mince métallique fragile ayant une épaisseur inférieure à 0,1 mm, comportant au moins une étape dans laquelle la bande mince est soumise à des contraintes, ce procédé permettant d'éviter des risques de rupture de la bande fragile pendant son traitement et d'obtenir en particulier des pièces de forme géométrique précise et/ou complexe à partir de la bande mince fragile.

A cet effet l'invention a pour objet un procédé de traitement d'au moins une bande mince métallique fragile en alliage magnétique doux à l'état nanocristallin ayant une épaisseur inférieure à 0,1 mm, selon lequel on recouvre la bande de matériau magnétique doux à l'état amorphe d'un mélange complexe constitué de solvants, de liants polymères, d'aluminates, de silicates et de fondants, qu'on sèche la bande recouverte de la couche de revêtement, on réalise une pluralité de bandes amorphes revêtues et séchées, on superpose la pluralité de bandes amorphes revêtues, on réalise une première cuisson des bandes amorphes revêtues, pour obtenir une bande stratifiée composite amorphe/polymère, on découpe des pièces dans la bande composite, on traite thermiquement les pièces découpées à une température permettant de développer une structure nanocristalline dans les bandes amorphes et de vitrifier le mélange aluminate, silicate et fondant, pour obtenir des pièces de forme découpées et comportant des couches nanocristallines et des couches vitrifiées stratifiées.

L'invention conceme également des pièces obtenues par le procédé selon l'invention, comme définies dans la revendication 8.

Afin de bien faire comprendre l'invention, on va maintenant décrire, à titre d'exemple, la mise en oeuvre d'un procédé suivant l'invention, pour la réalisation par découpage de composants magnétiques, à partir d'une bande en un alliage magnétique nanocristallin.

Le procédé suivant l'invention tel qu'il sera décrit par la suite est utilisé pour la fabrication de pièces magnétiques planes en un matériau magnétique, sous forme nanocristalline.

Le matériau magnétique est un matériau magnétique doux, généralement constitué par un alliage renfermant principalement du fer ou, éventuellement, un mélange de fer et d'un métal ferromagnétique tel que le nickel et le cobalt, ainsi que du cuivre, du silicium, du bore et un métal tel que le niobium.

Le matériau magnétique pourrait également contenir du fer, du zirconium et du bore et éventuellement du cuivre et du silicium.

Les alliages magnétiques auxquels s'applique l'invention sont donc par exemple des alliages Fe-Cu-Nb-B-Si ou Fe-Zr-(Cu)-B-(Si) (les parenthèses autour des symbbles Cu et Si indiquant que ces éléments peuvent être éventuellement absents).

L'invention peut bien sûr s'appliquer à d'autres alliages magnétiques.

A titre.d'exemple, on a élaboré un alliage à base de fer présentant la composition atomique suivante :

Fe_{73,5} Cu₁ Nb₃ Si_{13,5} B₉.

Les nombres donnés en indice des éléments de l'alliage corréspondent aux pourcentages atomiques de ces éléments dans l'alliage.

L'alliage de fer à l'état liquide est coulé sur un cylindre bon conducteur de la chaleur, efficacement refroidi, de manière à obtenir des bandes ou rubans à l'état amorphe d'une épaisseur de l'ordre de 20 µm et d'une largeur supérieure à 5 mm.

Le traitement selon l'invention est mis en oeuvre pour obtenir, par découpage de la bande, des pièces magnétiques de forme, en évitant une rupture de la bande métallique pendant le découpage. Le procédé de traitement suivant l'invention est mis en oeuvre sur une bande à l'état amorphe, et comporte un traitement thermique permettant ensuite de développer la structure nanocristalline, c'est-à-dire une structure à fins cristaux par exemple, une structure constituée d'au moins % en volume de grain d'une taille inférieure à 50 mm..

Le traitement thermique est un recuit à une température d'environ 550°C pendant une durée de l'ordre d'une heure.

Le traitement selon l'invention comporte une opération supplémentaire, par exemple d'usinage ou de formage de la bande métallique revêtue sur ses deux faces ou de la bande composite stratifiée, pour obtenir des pièces de forme, par exemple par découpage de la bande.

Du fait que les bandes stratifiées ou composites obtenues ne présentent plus de risque de rupture fragile pendant le découpage de pièces, on peut réaliser, à partir de ces bandes stratifiées ou composites, toute pièce magnétique par exemple en forme d'U ou en forme d'E, ou encore toute pièce magnétique de forme complexe utilisée en horlogerie, comme il sera expliqué plus loin.

Dans le cas où l'on désire fabriquer des composants magnétiques du type torique à cycle couché, c'est-à-dire dont le rapport Bᵣ/Bₛ est très inférieur à 1, le découpage des pièces sera réalisé de manière à créer des interfaces de rupture dans les pièces .composites découpées. Ces interfaces de rupture peuvent être réalisés par frappe, au moment du découpage.

Pour appliquer l'invention, on réalise un dépôt d'une couche de recouvrement renfermant un polymère sur une bande amorphe qui est ensuite découpée à la forme de pièces magnétiques, ces pièces étant ensuite traitées thermiquement pour développer dans le matériau amorphe des pièces une structure nanocristalline.

Les différentes étapes d'un tel procédé sont les suivantes :
1 - On réalise une enduction d'une ou des deux faces d'une bande amorphe, avec un mélange complexe de solvants qui peut être constitué d'eau, de liants polymères, d'aluminates, de silicates et de fondants.
2 - On sèche la couche d'enduction, de manière que le dépôt soit adhérent sur la bande amorphe.
3 - On superpose plusieurs bandes amorphes enduites sur leurs deux faces ou sur une seule face.
4 - On réalise une première cuisson de la colle inorganique pour obtenir un composite bande amorphe/colle inorganique découpable.
5 - On découpe les pièces dans le stratifié ainsi constitué.
6 - On traite thermiquement les pièces découpées à une température permettant la germination des nanocristaux dans la bande amorphe et une vitrification du mélange de poudres, aluminate, silicate et fondant.

Une température supérieure à 500°C peut convenir selon le type de mélange polymère, silicate, aluminate et fondant utilisé.

Le polymère est oxydé pendant le traitement thermique.

Pour constituer le mélange d'enduction de la bande amorphe, ce mélange étant à l'état pâteux, on peut utiliser les substances suivantes :
- une résine du type éthylcellulose qui assure la tenue mécanique du dépôt et confère la viscosité adaptée au type d'application ;
- des solvants, par exemple un mélange d'hydrocarbures aliphatiques ou aromatiques qui sont destinés à dissoudre la résine et qui doivent s'éliminer facilement par traitement à basse température, par exemple à 100°C ;
- une charge minérale, par exemple des verres ou oxydes, destinée à renforcer l'adhérence de la couche sur le matériau à l'état nanocristallin, après son traitement ;
- une charge organique, par exemple constituée par des substances organo-métalliques ou tensio-actives, destinée à améliorer la dispersion, le mouillage et la résistance à la corrosion de la couche de recouvrement.

Un exemple typique de composition de la substance d'enduction pâteuse est donné ci-dessous :
charge métallique : 40 à 70 parties par volume
résine : 3 à 10 parties par volume
charge minérale : 3 à 6 parties par volume
charges organiques : 0,5 à 2 parties par volume
solvant : le reste de la composition, jusqu'à 100 parties volumiques.

Le procédé suivant l'invention permet donc d'obtenir dans tous les cas des pièces magnétiques constituées de bandes minces en alliage nanocristallins sans risque de rupture des bandes.

Le procédé suivant l'invention permet d'obtenir des pièces magnétiques de formes complexes en alliage nanocristallin.

Par exemple, dans le cas de bandes nanocristallines d'une épaisseur de 20 µm recouvertes sur leurs deux faces par des couches en matériau polymère d'une épaisseur de 5 µm, un empilement de trois bandes stratifiées superposées présente une épaisseur de 80 µm, soit 0,08 mm.

On peut bien sûr réaliser des pièces magnétiques par découpage de bandes composites stratifiées plus épaisses, par exemple d'une épaisseur d'1 mm ou plus.

Dans un tel matériau composite stratifié, il est possible de réaliser des pièces de transformateurs en forme de E, de I ou de U.

De telles pièces de transformateurs présentent de très bonnes propriétés magnétiques, du fait qu'elles sont constituées par des couches d'alliage nanocristallin, et de très bonne propriétés mécaniques, du fait que les feuilles d'alliage nanocristallin sont protégées par des couches adhérentes sur toute leur surface. En outre, comme indiqué plus haut, pendant le découpage des produits composites stratifiés, le risque de rupture des bandes nanocristallines est extrêmement réduit.

Le découpage de ces pièces peut être réalisé par tout procédé de découpage mécanique de pièces de forme, par exemple par frappe à l'emporte-pièce.

La structure stratifiée des pièces obtenues est également favorable pour limiter les pertes par courants de Foucault dans ces pièces, lorsqu'elles sont utilisées comme pièces de transformateurs.

II est également possible d'utiliser des pièces découpées dans des matériaux composites stratifiés, selon le procédé de l'invention, qui puissent être utilisées comme noyaux toriques.

On peut, par exemple, réaliser des tores ayant la forme de rondelles découpées ou la forme de cadres à section carrée ou rectangulaire, évidés en leur centre.

On peut également, réaliser des tores avec entrefer ayant la forme de rondelles stratifiées comportant une fente radiale constituant un entrefer. Aussi bien le découpage des rondelles que la réalisation de la fente peuvent être réalisés sans risque de rupture des bandes nanocristallines constituant le produit composite stratifié. On obtient ainsi des tores coupés qui peuvent être de très petites dimensions ayant un cycle couché, c'est-à-dire un rapport Br/Bs très inférieur à 1.

De manière générale, les pièces obtenues peuvent être des pièces de petites ou de très petites dimensions qui présentent également une forme plate et une très faible épaisseur.

Il est possible également, de réaliser par le procédé de l'invention, des pièces pour circuits magnétiques minaturisés, par exemple pour réaliser des rotors ou stators de moteurs électriques de très petites dimensions telles que des moteurs électriques de montres.

Le procédé suivant l'invention peut être également utilisé pour réaliser des étiquettes antivol en matériau à haute perméabilité dont la présence sur un article ou objet peut être repérée lors du passage de l'objet dans une boucle d'un circuit parcourue par un courant. Le passage de l'objet portant l'étiquette antivol est alors détecté par la variation du courant induit dans la boucle.

On peut également réaliser par le procédé suivant l'invention des inductances ou transformateurs minces, ayant une épaisseur qui peut être par exemple de l'ordre d'un millimètre, permettant le montage de ces inductances ou transformateurs minces, contre une surface d'un dispositif.

Le procédé suivant l'invention permet d'éviter les risques de rupture des bandes minces en alliage nanocristallin ou éventuellement en alliage amorphe, pendant le formage des pièces magnétiques, par exemple par découpage ou perçage.

L'invention ne se limite pas au cas où l'on réalise un découpage des bandes dans une seconde étape du procédé mais s'applique à tous les cas où l'on réalise une manipulation ou un usinage sur des bandes métalliques minces fragiles, cette manipulation ou usinage entraînant une mise sous contrainte de la bande fragile.

L'invention peut s'appliquer dans des domaines différents de la fabrication de pièces magnétiques.

## Revendications

1. Procédé de traitement d'au moins une bande mince métallique fragile en alliage magnétique doux à l'état nanocristallin ayant une épaisseur inférieure à 0,1 mm, le procédé comprenant les phases suivantes: on recouvre la bande de matériau magnétique doux à l'état amorphe d'un mélange complexe constitué de solvants, de liants polymères, d'aluminates, de silicates et de fondants, on sèche la bande recouverte de la couche de revêtement, on réalise une pluralité de bandes amorphes revêtues et séchées, on superpose la pluralité de bandes amorphes revêtues, on réalise une première cuisson des bandes amorphes revêtues, pour obtenir une bande stratifiée composite amorphe/polymère, on découpe des pièces dans la bande composite, on traite thermiquement les pièces découpées à une température permettant de développer une structure nanocristalline dans les bandes amorphes et de vitrifier le mélange aluminate, silicate et fondant, pour obtenir des pièces de forme découpées et comportant des couches nanocristallines et des couches vitrifiées stratifiées.

2. Procédé suivant la revendication 1, **caractérisé par le fait qu'**on utilise dans le mélange de recouvrement de la bande une résine du type éthylcellulose, des solvants constitués par un mélange d'hydrocarbures aliphatiques ou aromatiques, une charge minérale constituée par des verres ou des oxydes et une charge organique constituée par des substances organo-métalliques ou tensio-actives.

3. Procédé suivant la revendication 1 ou la revendication 2, **caractérisé par le fait que** le découpage des pièces dans la bande composite est une opération de découpage mécanique.

4. Procédé suivant l'une quelconque des revendications 1 à 3, **caractérisé par le fait que** la couche de revêtement comportant un matériau polymère présente une épaisseur comprise entre 1 et 50 µm.

5. Procédé suivant l'une quelconque des revendications 1 à 4, **caractérisé par le fait que** la bande mince en matériau nanocristallin présente une épaisseur de l'ordre de 20 µm.

6. Procédé suivant l'une quelconque des revendications 1 à 5, **caractérisé par le fait que** le matériau magnétique doux renferme du fer, du cuivre, du niobium, du silicium et du bore ou encore du fer, du zirconium, du bore et éventuellement du cuivre et du silicium.

7. Procédé suivant la revendication 6, **caractérisé par le fait que** la composition atomique de l'alliage magnétique doux est par exemple du type Fe-Cu-Nb-B-Si ou du type Fe-Zr-(Cu)-B-(Si) ou autre.

8. Pièce magnétique comportant des bandes en alliage magnétique doux sous forme nanocristalline, traitées selon une de revendications 1-6, **caractérisée par le fait qu'**elle est réalisée sous forme stratifiée et qu'elle comporte au moins une bande en un matériau magnétique sous forme nanocristalline et au moins une couche de revêtement comportant au moins un film vitrifié superposée à la bande en alliage magnétique nanocristallin et adhérente sur cette bande en alliage magnétique nanocristallin.

9. Pièce magnétique suivant la revendication 8, **caractérisée par le fait qu'**elle constitue une pièce de transformateur plate ayant la forme d'un E, d'un I ou d'un U.

10. Pièce magnétique suivant la revendication 8, **caractérisée par le fait qu'**elle constitue un noyau magnétique torique en forme de rondelle ou en forme de cadre carré ou rectangulaire.

11. Pièce magnétique suivant la revendication 10, **caractérisée par le fait qu'**elle constitue un tore coupé présentant un entrefer de direction radiale.

12. Pièce magnétique suivant la revendication 8, **caractérisée par le fait qu'**elle constitue l'un des éléments suivants : pièce de circuit magnétique pour rotors ou stators de montres, rotor ou stator de moteur électrique, étiquette antivol, composant magnétique tel qu'inductance ou transformateur, en particulier inductance ou transformateur minces d'une épaisseur de l'ordre d'un millimètre.

## Patentansprüche

1. Verfahren zur Behandlung wenigstens eines dünnen metallischen brüchigen Streifens aus einer weichen magnetischen Legierung in nanokristallinem Zustand, welcher eine Dicke von weniger als 0,1 mm aufweist, wobei das Verfahren die nachfolgenden Phasen umfasst:
man beschichtet den Streifen aus dem weichen magnetischen Material in amorphem Zustand mit einem komplexen Gemisch bestehend aus Lösungsmitteln, polymeren Bindemitteln, Aluminaten, Silikaten und Zuschlägen, man trocknet den mit der Beschichtung bedeckten Streifen, man stellt eine Mehrzahl amorpher beschichteter und getrockneter Streifen her, man legt die Mehrzahl der amorphen beschichteten Streifen übereinander, man führt eine erste Erwärmung der amorphen beschichteten Streifen durch, um einen amorph/polymeren Verbundschichtstoffstreifen zu erhalten, man schneidet Stücke von dem Verbundstreifen ab (aus dem Verbundstreifen heraus), man behandelt die abgeschnittenen Stücke thermisch bei einer Temperatur, die es ermöglicht, eine nanokristalline Struktur in den amorphen Streifen zu entwickeln und das Gemisch aus Aluminat, Silikat und Zuschlägen zu verglasen, um Stücke in zugeschnittener Form zu erhalten, die nanokristalline Schichten und glasartige Schichten als Schichtstoff aufweisen.

2. Verfahren gemäß Anspruch 1, **dadurch gekennzeichnet, dass** man in dem Gemisch zur Beschichtung des Streifens ein Harz des Ethylzellulose-Typs verwendet, Lösungsmittel bestehend aus einem Gemisch aliphatischer oder aromatischer Kohlenwasserstoffe, einen mineralischen Zusatz bestehend aus Gläsern oder Oxiden und einen organischen Zusatz bestehend aus organo-metallischen oder oberflächenaktiven Substanzen.

3. Verfahren nach Anspruch 1 oder 2, **dadurch gekennzeichnet, dass** das Abschneiden/Herausschneiden von Stücken von/aus dem Verbundstreifen ein mechanischer Schneidvorgang ist.

4. Verfahren nach einem der Ansprüche 1 bis 3, **dadurch gekennzeichnet, dass** die ein polymeres Material umfassende Beschichtung eine Schichtdicke von etwa 1 bis etwa 50 µm aufweist.

5. Verfahren nach einem der Ansprüche 1 bis 4, **dadurch gekennzeichnet, dass** der dünne Streifen aus nanokristallinem Material eine Schichtdicke in der Größenordnung von 20 µm aufweist.

6. Verfahren nach einem der Ansprüche 1 bis 5, **dadurch gekennzeichnet, dass** das weiche magnetische Material Eisen, Kupfer, Niob, Silizium und Bor enthält oder Eisen, Zirkonium, Bor und gegebenenfalls Kupfer und Silizium.

7. Verfahren nach Anspruch 6, **dadurch gekennzeichnet, dass** die atomare Zusammensetzung der weichen magnetischen Legierung z. B. dem Typ Fe-Cu-Nb-B-Si oder dem Typ Fe-Zr-(Cu)-B-(Si) oder andere entspricht.

8. Magnetisches Teil umfassend Streifen aus weicher magnetischer Legierung in nanokristalliner Form, behandelt gemäß einem der Ansprüche 1 bis 6, **dadurch gekennzeichnet, dass** dieses in Form eines Schichtstoffs hergestellt wird und es wenigstens einen Streifen aus einem magnetischen Material in nanokristalliner Form umfasst und wenigstens eine Schicht einer Beschichtung umfassend wenigstens einen verglasten über den Streifen aus der magnetischen nanokristallinen Legierung gelegten Film, der an diesem Streifen aus der magnetischen nanokristallinen Legierung haftet.

9. Magnetisches Teil gemäß Anspruch 8, **dadurch gekennzeichnet, dass** dieses ein flaches Teil eines Transformators ist, welches die Form eines E, eines I oder eines U hat.

10. Magnetisches Teil gemäß Anspruch 8, **dadurch gekennzeichnet, dass** dieses einen ringförmigen magnetischen Kern bildet in Form einer Ringscheibe oder eines quadratischen oder rechteckigen Rahmens.

11. Magnetisches Teil gemäß Anspruch 10, **dadurch gekennzeichnet, dass** dieses einen geschnittenen Torus bildet, der einen Luftspalt in radialer Richtung aufweist.

12. Magnetisches Teil gemäß Anspruch 8, **dadurch gekennzeichnet, dass** dieses eines der nachfolgend genannten Elemente bildet: Teil eines Magnetkreises für Rotoren oder Statoren von Uhren, Rotoren oder Statoren von elektrischen Motoren, Anti-Diebstahl-Markierung, magnetische Komponente wie induktives Bauteil oder Transformator, insbesondere dünnes induktives Bauteil oder dünner Transformator mit einer Dicke in einer Größenordnung von einem Millimeter.

## Claims

1. Method of treating at least one fragile, thin metal strip in soft magnetic alloy in nanocrystalline state with a thickness of less than 0.1 mm, consisting of the following phases: recovery of the strip of soft magnetic material in amorphous state, in a complex mixture made up of solvents, polymer bonding agents, aluminates, silicates and fondant agents, drying of the strip in its covering layer, the production of a number of amorphous, coated, dried strips, which are then superimposed on each other, the first baking of the coated amorphous strips to obtain a compound amorphous/polymer layered strip, the cutting of the compound strip into sections, which are then subjected to thermal treatment at a temperature that allows a nanocrystalline structure to develop in the amorphous strips and the vitrification of the aluminate, silicate, fondant mixture, to obtain cut sections in the form of nanocrystalline layers and stratified, vitrified layers.

2. A method in accordance with claim 1, in which an ethylcellulose resin, solvents made up of a mixture of aliphatic or aromatic hydrocarbons, a mineral charge consisting of glasses or oxides and an organic charge consisting of organic-metallic or surfactant substances are used in the strip recovery mixture.

3. A method in accordance with claims 1 or 2, in which the sections of the compound strip are cut mechanically.

4. A method in accordance with claims 1 to 3, in which the coating layer in the form of a polymer material has a thickness from 1 to 50 µm.

5. A method in accordance with any of the claims 1 to 4, in which the thin nanocrystalline strip has a thickness in the region of 20 µm.

6. A method in accordance with any of the claims 1 to 5, in which the soft magnetic material contains iron, copper niobium, silicon and boron, or iron, zirconium, boron and possibly copper and silicon.

7. A method in accordance with claim 6, in which the atomic composition of the soft magnetic alloy is of the Fe-Cu-Nb-B-Si or Fe-Zr-(Cu)-B-(Si) type, for example, or of another type.

8. A magnetic component consisting of soft magnetic alloy strips in nanocrystalline form, treated in accordance with one of the claims 1 to 6, in stratified form, with at least one nanocrystalline magnetic strip and at least one covering layer consisting at least of a vitrified film superimposed over the nanocrystalline alloy strip, to which it adheres.

9. A magnetic component in accordance with claim 8, which makes up a part of a flat transformer with an E, I or U shape.

10. A magnetic component in accordance with claim 8, in the form of a toric magnetic core in the form of a circle or square or rectangular frame.

11. A magnetic component in accordance with claim 10, in the form of a cut torus with an air gap running in the radial direction.

12. A magnetic component in accordance with claim 8, forming one of the following elements: a part of a magnetic circuit for rotors or stators of watches, rotors or stators of electric motors, an anti-theft label, a magnetic component such as an inductance or transformer, and more specifically a thin inductance or transformer with a thickness in the region of one millimetre.
